# FASCICULE DE BREVET EUROPEEN

(11) **EP 2 955 876 B1**
(45) Date de publication et mention de la délivrance du brevet: **15.04.2020**
(21) Numéro de dépôt: 15171013.4
(22) Date de dépôt: 08.06.2015
(51) Int. Cl.: H04L 12/24

(54) **SIMULATEUR DE RÉSEAUX D'INTERCONNEXION ET PROCÉDÉ DE SIMULATION DE RÉSEAUX D'INTERCONNEXION**
SIMULATOR VON VERBINDUNGSNETZEN, UND SIMULATIONSVERFAHREN VON VERBINDUNGSNETZEN
INTERCONNECTION NETWORK SIMULATOR AND METHOD FOR SIMULATING INTERCONNECTION NETWORKS

(30) Priorité: 10.06.2014 FR 1455261
(43) Date de publication de la demande: 16.12.2015
(73) Titulaire: BULL SAS, 78340 Les Clayes sous Bois (FR)
(72) Inventeur: Cady, Alain, 91470 Limours en Hurepoix (FR); Bratu, Ben, 78000 Versailles (FR)
(74) Mandataire: Cabinet Camus Lebkiri

(56) Documents cités:
- US-A1- 2007 067 296
- US-A1- 2012 158 395
- US-B1- 7 225 117
- US-B1- 8 626 827

## Description

### DOMAINE TECHNIQUE

La présente invention se rapporte, dans le domaine de l'informatique, aux simulateurs de réseaux d'interconnexion permettant de prototyper, développer et tester des réseaux d'interconnexion ainsi que des logiciels de gestion de ces réseaux d'interconnexion. La présente invention concerne également un procédé de simulation de réseaux d'interconnexion. Cette invention est applicable à des supercalculateurs pouvant comporter plusieurs milliers de nœuds.

### ETAT DE LA TECHNIQUE ANTERIEUR

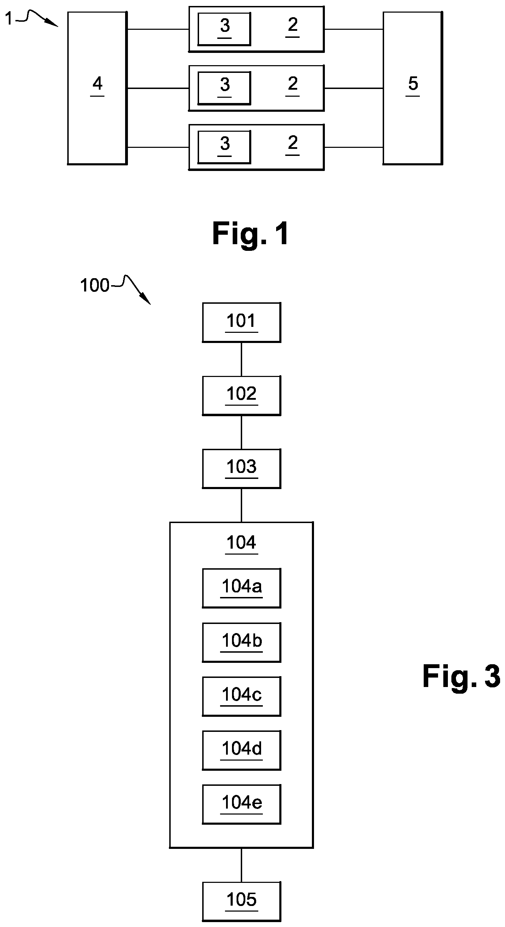

De façon connue, les supercalculateurs sont formés par la réunion de nœuds rassemblant chacun plusieurs processeurs. Ces supercalculateurs consistent ainsi à multiplier les processeurs, de manière à pouvoir exécuter simultanément un grand nombre de calculs. Comme illustré à la figure 1, ces supercalculateurs 1 connus dans l'art antérieur comprennent typiquement plusieurs nœuds 2 comprenant chacun un contrôleur de réseau 3 et reliés entre eux par un réseau 4 d'interconnexion. Par ailleurs, un réseau de gestion 5 interagit avec les nœuds 2 afin de les configurer, de les surveiller et de les administrer.

La fonction principale d'un réseau d'interconnexion est de transporter des données entre différents nœuds. Les réseaux d'interconnections sont donc un facteur limitant en terme de performance du supercalculateur, la performance de ce supercalculateur dépendant notamment de la latence de communication et de la bande passante. En d'autres termes, la performance de ces supercalculateurs dépend en partie de la performance des réseaux d'interconnexion.

Du fait du nombre important de connexions, de routeurs et de nœuds, la conception d'un tel réseau d'interconnexion est complexe. Afin de valider une conception, il est connu d'utiliser un simulateur permettant d'étudier et de valider les différents choix technologiques effectués lors de la conception d'un réseau d'interconnexion.

Des simulateurs à événements discrets tels que ns-2, OMNeT++/ OMNEST, SST ou encore simGrid considèrent des séquences d'événement dans le temps. En revanche, ils font abstraction de ce qui se passe dans l'intervalle de temps entre deux événements. Cependant, le comportement entre deux évènements est souvent nécessaire pour la simulation à grande échelle. Cette mise en œuvre interdit l'utilisation d'interface fonctionnelle en temps réel, par exemple de type SNMP. Avec ces approches, il n'est donc pas possible de simuler un réseau d'interconnexion à haut débit en temps réel. US 7 225 117 B1 décrit un outil de génération d'un réseau simulé à l'aide d'une interface utilisateur graphique (GUI), selon lequel une topologie de réseau générée sur une interface utilisateur graphique par un utilisateur est reçue, la topologie de réseau comprenant une pluralité de dispositifs et au moins une connexion entre des dispositifs. US 2007/067296 A1 décrit un simulateur de performances d'applications et de réseaux pour faciliter les études de déploiement d'applications et la planification des capacités de réseaux.

### EXPOSE DE L'INVENTION

L'invention a donc pour objectif de remédier aux inconvénients de l'état de la technique. Dans ce contexte, la présente invention a pour but de fournir un simulateur de réseaux d'interconnexion permettant de prototyper, de développer et de tester de manière efficace des réseaux d'interconnexion simulés pour des supercalculateurs à (très) large échelle.

A cette fin, l'invention porte sur un simulateur de réseaux d'interconnexion de nœuds de calcul, tel que revendiqué dans la revendication 1.

On entend pour la suite de la description par module simulé lancé un procédé de simulation simulant un module par exemple de type commutateur, ou encore de type contrôleur réseau.

Grâce au module de simulation de topologie, un utilisateur peut interagir avec un réseau d'interconnexion simulé de sorte à, par exemple, paramétrer au moins un des modules simulés lancés, définir un scénario de communication ou encore activer ou désactiver au moins un des modules simulés lancés ou au moins un des liens de connexion établi. Ainsi, grâce à ce module de simulation de topologie, le réseau d'interconnexion simulé est totalement paramétrable et modifiable de manière à déterminer une topologie de réseau d'interconnexion d'un supercalculateur comportant plus de 32.000 nœuds qui soit la plus performante possible.

Le simulateur de réseaux d'interconnexion selon l'invention peut également présenter une ou plusieurs des caractéristiques ci-après, considérées individuellement ou selon toutes les combinaisons techniquement réalisables.

Dans une mise en œuvre non limitative, les modules simulés lancés sont formés par une pluralité de modules de commutateur simulés lancés appartenant au réseau d'interconnexion et une pluralité de modules de contrôleur réseau simulés lancés appartenant audit réseau d'interconnexion.

Dans une mise en œuvre non limitative, les modules simulés lancés sont formés par une pluralité de module d'administration simulés lancés adaptés et construits pour simuler des interactions entre le réseau d'interconnexion simulé et un dispositif d'administration du réseau d'interconnexion simulé.

Dans une mise en œuvre non limitative, le module de simulation de topologie est adapté et construit pour permettre à un utilisateur d'interagir avec les modules simulés lancés en paramétrant au moins un des modules simulés lancés.

Dans une mise en œuvre non limitative, le module de simulation de topologie est adapté et construit pour permettre à un utilisateur d'interagir avec les modules simulés lancés en activant ou désactivant au moins un des modules simulés lancés.

Dans une mise en œuvre non limitative, le module de simulation de topologie est adapté et construit pour permettre à un utilisateur d'interagir avec les modules simulés lancés en :
- Attribuant un identifiant à chaque module simulé lancé, et
- Générant, pour chaque module simulé lancé, une carte locale décrivant les liens de connexion établis entre ledit module simulé lancé et ses modules simulés lancés avoisinant.

Dans une mise en œuvre non limitative, le module de simulation de topologie est adapté et construit pour permettre à un utilisateur d'interagir avec les modules simulés lancés en définissant des scénarios de communication.

Dans une mise en œuvre non limitative, au moins un des modules simulé lancé est adapté et construit pour générer des journaux de simulation.

L'invention porte également sur un procédé de simulation d'un réseau d'interconnexion de nœuds de calcul tel que revendiqué dans la revendication 6.

Dans une mise en œuvre non limitative, l'étape d'interaction comporte une sous-étape de paramétrage d'au moins un des modules simulés lancés.

Dans une mise en œuvre non limitative, l'étape d'interaction comporte une sous-étape de définition d'au moins un scénario de communication.

Dans une mise en œuvre non limitative, l'étape d'interaction comporte une sous-étape d'activation ou de désactivation d'au moins un module simulé lancé.

Dans une mise en œuvre non limitative, l'étape d'interaction comporte :
- une sous-étape d'attribution d'un identifiant de chaque module simulé lancé, et
- une sous-étape de génération pour chaque module simulé lancé d'une carte locale décrivant les liens de connexion établis entre ledit module simulé lancé et ses modules simulés avoisinant.

Dans une mise en œuvre non limitative, le procédé de simulation d'un réseau d'interconnexion selon un mode de mise en œuvre de l'invention comporte une étape de génération d'un journal de simulation, le journal de simulation étant généré par au moins un des modules simulés lancés. Les modes de réalisations préférés correspondent aux revendications dépendantes.

### BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- la figure 1 illustre un exemple de supercalculateur conforme à ceux de l'état de la technique,
- la figure 2 illustre, de façon schématique, un exemple non limitatif de réalisation d'un simulateur de réseaux d'interconnexion selon l'invention,
- la figure 3 illustre un synoptique des étapes d'un procédé de simulation d'un réseau d'interconnexion selon l'invention.

Pour des raisons de clarté, seuls les éléments utiles pour la compréhension de l'invention ont été représentés et ceci, sans respect de l'échelle et de manière schématique. En outre, les éléments similaires situés sur différentes figures comportent des références identiques.

### DESCRIPTION DETAILLEE D'AU MOINS UN MODE DE REALISATION DE L'INVENTION

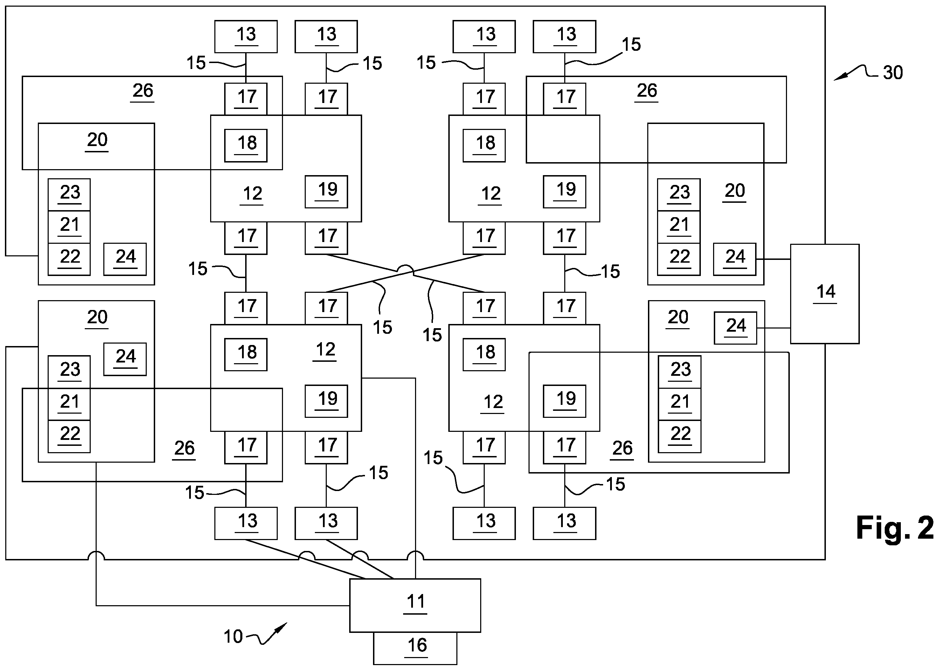

La figure 2 illustre notamment un simulateur de réseaux d'interconnexion 10 de nœuds de calcul conforme à l'invention ainsi qu'un réseau d'interconnexion simulé 30.

Plus particulièrement, le simulateur de réseaux d'interconnexion 10 de nœuds de calcul selon l'invention comporte un module de simulation de topologie 11 adapté et construit pour :
- sélectionner et lancer un nombre défini de modules simulés,
- établir des liens de connexion entre lesdits modules simulés lancés de sorte à former un réseau d'interconnexion simulé,
- permettre à un utilisateur d'interagir avec lesdits modules simulés.

Plus particulièrement, les modules simulés lancés par le module de simulation de topologie 11 sont formés dans l'exemple illustré sur la figure 2 par :
- quatre modules de commutateur simulés 12,
- huit modules de contrôleur réseau simulés 13,
- quatre modules d'administration 20 simulés, chacun des modules d'administration simulé 20 étant adapté et construit pour simuler des interactions entre le réseau d'interconnexion simulé 30 et un dispositif d'administration simulé 14 du réseau d'interconnexion simulé 30,

Il convient de noter que les modules de commutateur simulés lancés 12 et les modules de contrôleur réseau simulés lancés 13 appartiennent au réseau d'interconnexion 30. En revanche, les modules d'administration simulés lancés 20 sont à l'interface entre le réseau d'interconnexion simulé 30 et le dispositif d'administration 14. En d'autres termes, les modules d'administration simulés lancés 20 simulent les interactions entre le réseau d'interconnexion simulé 30 et le dispositif d'administration 14 du réseau d'interconnexion simulé 30.

En outre, dans l'exemple illustré, le réseau d'interconnexion simulé 30 comporte douze liens de connexion simulé 15.

Pour des raisons de clarté, le nombre de modules simulés lancés qui sont représentés sur la figure 2 est limité.

Chaque module de contrôleur réseau simulé 13 est donc sélectionné et lancé par le module de simulation de topologie 11, le module de simulation de topologie pouvant être implémenté sur un ordinateur ou processeur. De manière générale, chaque module de contrôleur réseau simulé lancé 13 simule une interface réseau de type hardware permettant aux nœuds d'échanger des informations.

Il convient de noter que le module de simulation de topologie 11 est en outre adapté et construit pour permettre à un utilisateur d'interagir avec les modules de contrôleur réseau simulés 13 lancés en définissant des scénarios de communication. Ainsi, un utilisateur peut simuler, via une interface utilisateur 16 connectée au module de simulation de topologie 11, un scénario de communication en commandant des transmissions et/ou réceptions de données selon un format spécifique. Ces données peuvent, par exemple, être transmises par les modules de contrôleur réseau simulés lancés 13 sous forme de paquets de données. Un scénario peut consister à découper un message sous forme de paquets de données où chaque paquet de données présente une taille réduite, par exemple 20 octets, et où chaque paquet de données présente une entête spécifique.

En outre, ces scénarios de communication peuvent être utilisés pour tester des séquences et des fréquences de transmission des modules de contrôleur réseau simulés lancés 13.

De manière générale, les scénarios de communication testés permettent de valider les choix techniques effectués lors de la conception d'un réseau d'interconnexion.

En outre, le module de simulation de topologie 11 est adapté et construit pour permettre à un utilisateur d'interagir avec les modules simulés lancés en paramétrant au moins un des modules de contrôleur réseau simulé lancé 13. Par exemple, le paramétrage d'un module de contrôleur réseau simulé 13 lancé est réalisé via un procédé de type MPI implémenté en C++. Un procédé, utilisant certaines fonctionnalités de la bibliothèque MPI, permet de forcer la transmission de données selon un lien de connexion 15 déterminé.

De manière générale et non limitative, le module de simulation de topologie 11 associé aux modules de contrôleur réseau simulés lancés 13 permettent de tester :
- un nombre itérations de transmission de données,
- un temps entre deux itérations de transmission de données,
- des tailles des données transmises et reçues par chaque module de contrôleur réseau simulé lancé 13,
- des transmissions descendantes et montantes de données,
- des modifications d'identifiant du module de contrôleur réseau simulé lancé 13,
- des transmissions d'accusé-réception des données reçus par chaque module de contrôleur réseau simulé lancé 13,
- des transmissions de données erronées, par exemple via la transmission d'un paquet de données corrompu ou encore la perte de ce dernier.

Ces modules de contrôleur réseau simulés 13 lancés et paramétrés via le module de simulation de topologie 11 permettent donc de simuler des scénarios de communication très proches des communications réelles réalisées au travers d'un réel supercalculateur muni d'un réseau d'interconnexion de type haut débit.

Dans une mise en œuvre non limitative, chaque module de contrôleur réseau simulé lancé 13 est adapté et construit pour générer des journaux de simulation. Ainsi, toutes les informations de test peuvent être transmises par chaque module de contrôleur réseau simulé lancé 13 sous forme de journal de simulation au module de simulation de topologie 11 pour être agrégées, analysées et affichées sur un écran de visualisation.

Par ailleurs, chaque module de commutateur simulé 12 est sélectionné et lancé par le module de simulation de topologie 11. Dans l'exemple illustré, chaque module de commutateur simulé lancé 12 comporte des sous-modules de commutateur. Plus particulièrement, dans l'exemple illustré, chaque module de commutateur simulé lancé 12 simule quatre ports de connexion 17, un commutateur à barres croisées 18, et une mémoire tampon 19.

Dans une mise en œuvre non limitative, le module de simulation de topologie 11 est adapté et construit pour permettre à un utilisateur d'interagir avec les modules simulés lancés en paramétrant au moins un des modules de commutateur simulé 12 lancé.

Dans une mise en œuvre non limitative, le module de simulation de topologie 11 est adapté et construit pour permettre à un utilisateur d'interagir avec les modules simulés lancés en paramétrant au moins un des sous-modules de commutateur 17, 18 et 19. Ainsi, il est possible de paramétrer, via le module de simulation de topologie, le nombre de ports de connexion 17, la disposition des commutateurs à barres croisées 18 et la capacité des mémoires tampons 19. Ce paramétrage permet donc de simuler différents choix de type matériel et logiciel d'un réseau d'interconnexion.

Dans une mise en œuvre non limitative, le module de simulation de topologie 11 est adapté et construit pour permettre à un utilisateur d'interagir avec les modules de contrôleur réseau 13 lancés en définissant des scénarios de communication. Lors de la mise en œuvre d'un scénario de communication, chaque module de commutateur simulé lancé 12 est indépendant et agit comme un réel module de commutateur adapté et construit pour recevoir et transmettre des message dans le réseau d'interconnexion en conformité avec ses tables de routages et en tenant compte du trafic réseau. Plus particulièrement, chaque module de commutateur 12 simulé lancé est adapté pour recevoir des données en provenance de n'importe quel module ou dispositif connecté à lui et puis transmettre les données uniquement au module ou dispositif pour lequel les données sont destinées.

Dans un exemple non limitatif, chaque module de commutateur simulé 12 est lancé via le module de simulation de topologie 11 au moyen d'un procédé indépendant de type MPI.

Dans un exemple non limitatif, les scénarios de communication définis au moyen du module de simulation de topologie 11 permettent :
- pour chaque module de commutateur simulé 12 lancé, de simuler, par exemple, une modification de l'identifiant du module de commutateur simulé 12 lancé dès lors qu'un nouveau lien de connexion 15 connecté audit module de commutateur simulé 12 lancé est créé ou supprimé,
- De simuler le comportement d'un module de commutateur, par exemple, lorsque des données sont routées par un module de commutateur simulé 12 lancé selon une table de routage prédéfinie,
- De simuler le comportement de chacun des sous-modules 17, 18 et 19.

Par ailleurs, le module de simulation de topologie 11 est adapté et construit pour activer et désactiver chacun des modules de commutateur 12 simulé ainsi que les ports connexion 17. Cette particularité permet donc une vérification fonctionnelle des scénarios de communication. Cette caractéristique est envisageable car chaque module de commutateur simulé 12 lancé est indépendant.

Dans une mise en œuvre non limitative, le module de simulation de topologie 11 est également adapté et construit pour sélectionner et lancer des modules d'administration simulés 20. De manière générale, chaque module d'administration simulé 20 lancé est adapté et construit pour simuler des interactions entre un module de commutateur 12 et un dispositif d'administration 14.

Dans l'exemple illustré, chaque module d'administration simulé 20 lancé comporte des sous-modules d'administration. Plus particulièrement, chaque module d'administration simulé 20 lancé comporte au moins une mémoire interne 21, un agent programmable 22, des compteurs internes 23 et une interface réseau d'administration 24. Cette interface réseau d'administration 24 permet de simuler un accès externe pour la connexion du dispositif d'administration 14.

Dans une mise en œuvre non limitative, le module de simulation de topologie 11 est adapté et construit pour permettre à un utilisateur d'interagir avec les modules simulés lancés en paramétrant au moins un des modules d'administration simulé 20 lancé.

Dans une mise en œuvre non limitative, le module de simulation de topologie 11 est adapté et construit pour permettre à un utilisateur d'interagir avec les modules simulés lancés en paramétrant au moins un des sous-modules d'administration 21, 22, 23 et 24.

Chaque module d'administration simulé 20 lancé est paramétrable via le module de simulation de topologie 11 de sorte à
- Implémenter un procédé de type MIB reflétant un agent SNMP répondant aux commandes du dispositif d'administration 14 (le dispositif d'administration 14 correspond à un logiciel d'administration du réseau d'interconnexion, également dénommé Fabric management selon la terminologie anglo-saxonne),
- Aiguiller les requêtes de type SNMPv3 transmises par le dispositif d'administration 14 à un module d'administration 20, les requêtes peuvent par exemple comporter une mise à jour d'une table de routage ou encore une mise à jour des compteurs internes,
- Simuler une couche de type CSR reflétant une implémentation matérielle dans une mémoire partagée 26, ou
- Autoriser la transmission d'informations de pilotage et de performance au dispositif d'administration 14 via un mécanisme de type SNMP INFORM.

Dans une implémentation réelle d'un réseau d'interconnexion, un protocole de communication, par exemple de type JTAG, est mis en œuvre entre un module de commutateur et un module d'administration communiquant avec ce module de commutateur.

Dans le cadre de l'invention, le simulateur de réseau d'interconnexion 10 selon l'invention est adapté et construit pour simuler ce protocole de communication entre un module de commutateur simulé 12 lancé et un module d'administration simulé 20 lancé. Pour ce faire, une même mémoire 26 est partagée entre un module de commutateur simulé 12 lancé et un module d'administration simulé 20 lancé. Le protocole de communication entre un module de commutateur simulé 12 lancé et un module d'administration simulé 20 lancé n'est pas réellement implémenté mais est simulé en paramétrant :
- Pour le module de commutateur simulé 12 lancé, un premier temps d'accès à la mémoire partagée 26,
- Pour le module d'administration simulé 20 lancé, un deuxième temps d'accès à la mémoire partagée 26.

De manière générale, le module de simulation de topologie 11 est adapté et construit pour sélectionner et lancer un nombre défini de modules simulés, par exemple dans le cas illustré à la figure 2, quatre commutateurs simulés, huit modules de contrôleur réseau simulés et quatre module d'administration simulés.

En outre, ce module de simulation de topologie 11 est adapté et construit pour distribuer ces modules simulés lancés sur des ressources matérielles. Pour ce faire, il est possible d'utiliser une solution de type SLURM (pour Simple Linux Utility for Resource Management).

En outre, ce module de simulation de topologie 11 est adapté et construit pour établir des liens de connexions entre les modules simulés lancés de sorte à former un réseau d'interconnexion simulé.

En outre, ce module de simulation de topologie 11 est adapté et construit pour permettre à un utilisateur d'interagir avec l'ensemble des modules simulés lancés et plus particulièrement avec le réseau d'interconnexion simulé.

En outre, ce module de simulation de topologie 11 est adapté et construit pour attribuer un identifiant à chaque module simulé lancé. Chaque identifiant peut être formé par un nombre. A partir de ces identifiants attribués, le module de simulation de topologie 11 peut définir une carte locale décrivant les liens de connexion établis entre un module simulé lancé du réseau d'interconnexion et ses modules simulés lancés avoisinant.

De manière générale, le module de simulation de topologie 11 est un point d'entrée permettant d'interagir directement avec un réseau d'interconnexion simulé. Un utilisateur peut ainsi via ce module de simulation de topologie 11, pouvant par exemple être implémenté sur un ordinateur, définir des scénarios de communication, paramétrer chaque module simulé lancé ou encore activer ou désactiver certain modules simulés lancés. Par exemple, un utilisateur peut ainsi via ce module de simulation de topologie 11 :
▪ ajouter et/ou supprimer des liens de connexion entre les modules simulés lancés,
▪ Paramétrer et/ou ajouter et/ou supprimer et/ou désactiver et/ou activer des modules de commutateur simulés lancés,
▪ Paramétrer et/ou ajouter et/ou supprimer et/ou désactiver et/ou activer des modules d'administration simulés lancés,
▪ Paramétrer et/ou ajouter et/ou supprimer et/ou désactiver et/ou activer des sous-modules, par exemple des ports de connexion,
▪ Revenir à la topologie initiale,
▪ Définir, pour chaque module simulé lancé, des scénarios de communication.

Il convient également de noter que chaque module simulé lancé peut être adapté et construit pour générer des journaux de simulation. Ainsi, lorsqu'un scénario de communication est défini puis mis en œuvre, chacun des modules simulés lancés transmet des journaux de simulation à l'interface utilisateur 16 pouvant par exemple être formée par un écran. De ce fait, l'utilisateur peut analyser les journaux de simulation. Un journal de simulation peut par exemple indiquer les changements d'état d'un module simulé lancé ou encore les données qui ont transitées par ledit module.

L'invention porte également sur un procédé de simulation d'un réseau d'interconnexion 100 de nœuds de calcul. Le procédé 100 comporte notamment une étape de :
- sélection 101 d'un nombre défini de modules simulés 12, 13, 20, la sélection étant réalisée par un module de simulation de topologie 11,
- lancement 102 dudit nombre défini de modules simulés 12, 13, 20, le lancement 102 étant réalisé par le module de simulation de topologie 11,
- établissement 103 de liens de connexion 15 entre les modules simulés 12, 13 lancés de sorte à former un réseau d'interconnexion simulé 30,
- interaction 104 d'un utilisateur avec lesdits modules simulés 12, 13, 20 lancés, ladite interaction 104 étant réalisée par le module de simulation de topologie 11.

Le procédé 100 peut également comporter une étape optionnelle de génération d'un journal de simulation 105. Chaque module simulé 12, 13 ou 20 peut ainsi générer un journal de simulation.

L'étape d'interaction 104 entre un utilisateur et un réseau d'interconnexion simulé peut mettre en œuvre, de façon isolée ou combinée, les sous-étapes suivantes :
- paramétrage 104a d'au moins un des modules simulés lancés 12, 13, 20,
- définition 104b, pour chaque module simulé lancé 12, 13, 20, d'au moins un scénario de communication,
- activation et/ou désactivation 104c d'au moins un modules simulés lancés 12, 13, 20,
- attribution 104d d'un identifiant de chaque module simulé 12, 13,
- génération 104e, pour chaque module simulé 12, 13 d'une carte locale décrivant les liens de connexion 15 établis entre ledit module simulé 12, 13 et ses modules simulés lancés avoisinant.

Il convient de noter que les étapes du procédé 100 représentées sur la figure 3, le module de simulation de topologie 11 ainsi que l'ensemble des modules simulés lancés, par exemple, les modules de commutateur 12, les modules de contrôleur réseau 13 ou les modules d'administration 20 représentés sur la figure 2 peuvent être implémentés sur un unique processeur, ou sur une pluralité de processeurs individuels, dont certains peuvent être partagés.

## Revendications

1. Simulateur de réseau d'interconnexion (10) de nœuds de calcul, ledit simulateur de réseau d'interconnexion (10) comportant un module de simulation de topologie (11) adapté et construit pour :
- sélectionner et lancer un nombre défini de modules simulés (12, 13, 20) les modules simulés lancés étant formés par :
o une pluralité de modules de commutateur simulés lancés (12) appartenant au réseau d'interconnexion (30),
o une pluralité de modules de contrôleur réseau simulés lancés (13) appartenant audit réseau d'interconnexion (30),
o une pluralité de module d'administration simulés lancés (20) adaptés et construits pour simuler des interactions entre le réseau d'interconnexion simulé (30) et un dispositif d'administration (14) du réseau d'interconnexion simulé (30),
- générer, par les modules de contrôleur simulés (12, 13, 20) lancés, des journaux de simulation, transmettre lesdits journaux de simulation au module de simulation de topologie, agréger, analyser et afficher lesdits journaux de simulation sur un écran d'une interface utilisateur,
- établir des liens de connexion (15) entre lesdits modules simulés (12, 13) lancés de sorte à former un réseau d'interconnexion simulé (30),
- permettre à un utilisateur d'interagir avec lesdits modules simulés (12, 13, 20) lancés à travers ladite interface utilisateur

2. Simulateur de réseau d'interconnexion (10) selon l'une quelconque des revendications précédentes, selon lequel le module de simulation de topologie (11) est adapté et construit pour permettre à un utilisateur d'interagir avec les modules simulés (12, 13, 20) lancés en paramétrant au moins un des modules simulés (12, 13, 20) lancés.

3. Simulateur de réseau d'interconnexion (10) selon l'une quelconque des revendications précédentes, selon lequel le module de simulation de topologie (11) est adapté et construit pour permettre à un utilisateur d'interagir avec les modules simulés (12, 13, 20) lancés en activant ou désactivant au moins un des modules simulés (12, 13, 20) lancés.

4. Simulateur de réseau d'interconnexion (10) selon l'une quelconque des revendications précédentes, selon lequel le module de simulation de topologie (11) est adapté et construit pour permettre à un utilisateur d'interagir avec les modules simulés (12, 13) lancés en :
- Attribuant un identifiant à chaque module simulé (12, 13) lancé, et
- Générant, pour chaque module simulé (12, 13) lancé, une carte locale décrivant les liens de connexion (15) établis entre ledit module simulé (12, 13) lancé et ses modules simulés lancés avoisinant.

5. Simulateur de réseau d'interconnexion (10) selon l'une quelconque des revendications précédentes, selon lequel le module de simulation de topologie (11) est adapté et construit pour permettre à un utilisateur d'interagir avec les modules simulés (13) lancés en définissant des scénarios de communication.

6. Procédé de simulation d'un réseau d'interconnexion (100) de nœuds de calcul, ledit procédé (100) comportant une étape de :
- sélection (101) d'un nombre défini de modules simulés (12, 13, 30), ladite sélection étant réalisée par un module de simulation de topologie (11) les modules simulés étant formés de :
∘ une pluralité de modules de commutateur simulés appartenant au réseau d'interconnexion (30),
∘ une pluralité de modules de contrôleur réseau simulés (13) appartenant audit réseau d'interconnexion (30),
∘ une pluralité de module d'administration simulés (20) adaptés et construits pour simuler des interactions entre le réseau d'interconnexion simulé (30) et un dispositif d'administration (14) du réseau d'interconnexion simulé (30),
- lancement (102) dudit nombre défini de modules simulés (12, 13, 20), ledit lancement (102) étant réalisé par le module de simulation de topologie (11),
- établissement (103) de liens de connexion (15) entre lesdits modules simulés (12, 13) lancés de sorte à former un réseau d'interconnexion simulé (30), ledit établissement (103) étant réalisé par le module de simulation de topologie (11),
- génération de journaux de simulation (105), les journaux de simulation étant générés par les modules simulés (12, 13, 20) lancés, transmission desdits journaux de simulation ai module de simulation de topologie, agrégation, analyse et affichage desdits journaux de simulation sur un écran d'une interface utilisateur,
- interaction (104) d'un utilisateur avec lesdits modules simulés (12, 13, 20) lancés, ladite interaction (104) étant réalisée via le module de simulation de topologie (11) à travers ladite interface utilisateur.

7. Procédé de simulation d'un réseau d'interconnexion (100) selon la revendication 9, selon lequel l'interaction (104) comporte une sous-étape de paramétrage (104a) d'au moins un des modules simulés (12, 13, 20) lancés.

8. Procédé de simulation d'un réseau d'interconnexion (100) selon l'une des revendications 9 ou 10, selon lequel l'interaction (104) comporte une sous-étape de définition (104b) d'au moins un scénario de communication.

9. Procédé de simulation d'un réseau d'interconnexion (100) selon l'une quelconque des revendications 9 à 11, selon lequel l'interaction (104) comporte une sous-étape d'activation ou de désactivation (104c) d'au moins un modules simulés (12, 13, 20) lancés.

10. Procédé de simulation d'un réseau d'interconnexion (100) selon l'une quelconque des revendications 9 à 12, selon lequel l'interaction (104) comporte :
- une sous-étape d'attribution (104d) d'un identifiant de chaque module simulé (12, 13) lancé, et
- une sous-étape de génération (104e) pour chaque module simulé (12, 13) lancé d'une carte locale décrivant les liens de connexion (15) établis entre ledit module simulé (12, 13) lancé et ses modules simulés avoisinant.

## Patentansprüche

1. Netzanschlussnetz-Simulator (10) von Berechnungsknoten, wobei der genannte Netzanschlussnetz-Simulator (10) ein Topologie-Simulationsmodul (11) umfasst, das geeignet und konstruiert ist, zum:
- Auswählen und Starten einer definierten Anzahl von simulierten Modulen (12, 13, 20), wobei die gestarteten, simulierten Module gebildet sind durch:
∘ eine Vielzahl von gestarteten, simulierten Umschaltmodulen (12), die zu dem Netzanschlussnetz (30) gehören,
∘ eine Vielzahl von gestarteten, simulierten Netzsteuer-Modulen (13), die zu dem genannten Netzanschlussnetz (30) gehören;
∘ eine Vielzahl von gestarteten, simulierten Verwaltungsmodulen (20), die zum Simulieren der Interaktionen zwischen dem simulierten Netzanschlussnetz (30) und einer Verwaltungsvorrichtung (14) des simulierten Netzanschlussnetzes (30) geeignet und konstruiert sind;
- Erzeugen der Simulations-Tagebücher durch die simulierten Steuermodule (12, 13, 20), Übertragen der genannten Simulations-Tagebücher auf das Topologie-Simulationsmodul, Zusammenfügen, Analysieren und Anzeigen der genannten Simulations-Tagebücher auf einem Bildschirm einer Nutzerschnittstelle,
- Aufbauen der Anschlusslinks (15) zwischen den genannten simulierten Modulen (12, 13), die derart gestartet sind, dass ein simulierter Netzanschlussnetz (30) geformt ist
- einem Nutzer Erlauben, mit den genannten gestarteten, simulierten Modulen (12, 13, 20) durch die genannte Nutzerschnittstelle zu interagieren.

2. Netzanschlussnetz-Simulator (10) gemäß irgendeinem der voranstehenden Ansprüche, gemäß dem das Topologie-Simulationsmodul (11) geeignet und konstruiert ist, um einem Nutzer das Interagieren mit den gestarteten, simulierten Modulen (12, 13, 20) durch Parametrieren wenigstens eines der gestarteten, simulierten Module (12, 13, 20) zu erlauben.

3. Netzanschlussnetz-Simulator (10) gemäß irgendeinem der voranstehenden Ansprüche, gemäß dem das Topologie-Simulationsmodul (11) geeignet und konstruiert ist, um einem Nutzer das Interagieren mit den gestarteten, simulierten Modulen (12, 13, 20) durch Aktivieren oder Deaktivieren wenigstens eines der gestarteten, simulierten Module (12, 13, 20) zu erlauben.

4. Netzanschlussnetz-Simulator (10) gemäß irgendeinem der voranstehenden Ansprüche, gemäß dem das Topologie-Simulationsmodul (11) geeignet und konstruiert ist, um einem Nutzer das Interagieren mit den gestarteten, simulierten Modulen (12, 13) zu erlauben durch:
- Zuordnen einer Kennung zu jedem gestarteten, simulierten Modul (12, 13, 20) und,
- Erzeugen einer lokalen Karte für jedes gestartete, simulierte Modul (12, 13), die die Anschlusslinks (15) beschreibt, die zwischen dem genannten gestarteten, simulierten Modul (12, 13) und seinen benachbarten gestarteten, simulierten Modulen aufgebaut sind.

5. Netzanschlussnetz-Simulator (10) gemäß irgendeinem der voranstehenden Ansprüche, gemäß dem das Topologie-Simulationsmodul (11) geeignet und konstruiert ist, um einem Nutzer das Interagieren mit den gestarteten, simulierten Modulen (13) durch Definieren der Kommunikationsszenarien zu erlauben.

6. Simulationsverfahren eines Netzanschlussnetzes (100) von Berechnungsknoten, wobei das genannte Verfahren (100) einen Schritt umfasst zum:
- Auswählen (101) einer definierten Anzahl von simulierten Modulen (12, 13, 30), wobei das genannte Auswählen durch ein Topologie-Simulationsmodul (11) realisiert wird, wobei die simulierten Module gebildet werden aus:
∘ einer Vielzahl von simulierten Schaltermodulen, die zu dem Netzanschlussnetz (30) gehören;
∘ einer Vielzahl von simulierten Netzsteuermodulen (13), die zu dem genannten Netzanschlussnetz (30) gehören;
∘ einer Vielzahl von simulierten Verwaltungsmodulen (20), die geeignet und konstruiert sind, um die Interaktionen zwischen dem simulierten Netzanschlussnetz (30) und einer Verwaltungsvorrichtung (14) des simulierten Netzanschlussnetzes (30) zu simulieren,
- Starten (102) der genannten definierten Anzahl von simulierten Modulen (12, 13, 20), wobei das genannte Starten (102) durch das Topologie-Simulationsmodul (11) realisiert wird,
- Aufbauen (103) von Anschlusslinks (15) zwischen den genannten gestarteten, simulierten Modulen (12, 13) derart, dass ein simuliertes Netzanschlussnetz (30) geformt ist, wobei das genannte Aufbauen (103) durch das Topologie-Simulationsmodul (11) realisiert wird,
- Erzeugen von Simulations-Tagebüchern (105), wobei die Simulationstagebücher durch die gestarteten, simulierten Module (12, 13, 20) erzeugt werden, Übertragung der genannten Simulations-Tagebücher auf das Topologie-Simulationsmodul, Zusammenfügen, Analysieren und Anzeigen der genannten Simulations-Tagebücher auf einem Bildschirm einer Nutzerschnittstelle,
- Interaktion (104) eines Nutzers mit den genannten gestarteten, simulierten Modulen (12, 13, 20), wobei die genannte Interaktion (104) über das Topologie-Simulationsmodul (11) über die genannte Nutzerschnittstelle realisiert wird.

7. Simulationsverfahren eines Netzanschlussnetzes (100) gemäß Anspruch 6, gemäß dem die Interaktion (104) einen Parametrierungs-Teilschritt (104a) wenigstens eines der gestarteten, simulierten Module (12, 13, 20) umfasst.

8. Simulationsverfahren eines Netzanschlussnetzes (100) gemäß irgendeinem der Ansprüche 6 oder 7, gemäß dem die Interaktion (104) einen Definitions-Teilschritt (104b) wenigstens eines Kommunikationsszenarios umfasst.

9. Simulationsverfahren eines Netzanschlussnetzes (100) gemäß irgendeinem der Ansprüche 6 bis 8, gemäß dem die Interaktion (100) einen Aktivierungs- oder Deaktivierungs-Teilschritt (104c) wenigstens eines der gestarteten, simulierten Module (12, 13, 20) umfasst.

10. Simulationsverfahren eines Netzanschlussnetzes (100) gemäß irgendeinem der Ansprüche 6 bis 9, gemäß dem die Interaktion (104) umfasst:
- einen Zuordnungs-Teilschritt (104d) einer Kennung jedes gestarteten, simulierten Moduls (12, 13) und
- einen Erzeugungs-Teilschritt (104e) für jedes gestartete, simulierte Modul (12, 13) einer lokalen Karte, die die Anschlusslinks (15) beschreibt, die zwischen dem genannten gestarteten, simulierten Modul (12, 13) und seinen benachbarten, simulierten Modulen aufgebaut sind.

## Claims

1. An interconnection network simulator (10) for computational nodes, said interconnection network simulator (10) including a topology simulation module (11) adapted and built to:
- select and launch a defined number of simulated modules (12, 13, 20), the simulated modules launched being formed by:
∘ a plurality of launched simulated switch modules (12) belonging to the interconnection network (30),
∘ a plurality of launched simulated network controller modules (13) belonging to said interconnection network (30),
∘ a plurality of launched simulated management modules (20) adapted and built to simulate interactions between the simulated interconnection network (30) and a management device (14) for the simulated interconnection network (30),
- generate, by the launched simulated controller modules (12, 13, 20), simulation logs, transmit said simulation logs to the topology simulated module, aggregate, analyse and display said simulation logs on a screen of a user interface,
- establish connection links (15) between said launched simulated modules (12, 13) so as to form a simulated interconnection network (30),
- enable a user to interact with said launched simulated modules (12, 13, 20) through said user interface.

2. The interconnection network simulator (10) according to any of the previous claims, wherein the topology simulation module (11) is adapted and built to enable a user to interact with the simulated modules (12, 13, 20) launched by parameterising at least one of the simulated modules (12, 13, 20) launched.

3. The interconnection network simulator (10) according to any of the previous claims, wherein the topology simulation module (11) is adapted and built to enable a user to interact with the simulated modules (12, 13, 20) launched by activating or deactivating at least one of the simulated modules (12, 13, 20) launched.

4. The interconnection network simulator (10) according to any of the previous claims, wherein the topology simulation module (11) is adapted and built to enable a user to interact with the simulated modules (12, 13) launched by:
- assigning an identifier to each simulated module (12, 13) launched, and
- generating, for each simulated module (12, 13) launched, a local map describing the connection links (15) established between the simulated module (12, 13) launched and its neighbouring simulated modules launched.

5. The interconnection network simulator (10) according to any of the previous claims, wherein the topology simulation module (11) is adapted and built to enable a user to interact with the simulated modules (13) launched by defining communication scenarios.

6. A method for simulating an interconnection network (100) for computational nodes, said method (100) including a step of:
- selecting (101) a defined number of simulated modules (12, 13, 30), said selecting being performed by a topology simulation module (11), the simulated modules being formed by:
∘ a plurality of simulated switch modules belonging to the interconnection network (30),
∘ a plurality of simulated network controller modules (13) belonging to said interconnection network (30),
∘ a plurality of simulated management modules (20) adapted and built to simulate interactions between the simulated interconnection network (30) and a management device (14) for the simulated interconnection network (30),
- launching (102) said defined number of simulated modules (12, 13, 20), said launching (102) being performed by the topology simulation module (11),
- establishing (103) connection links (15) between said simulated modules (12, 13) launched so as to form a simulated interconnection network (30), said establishing (103) being performed by the topology simulation module (11),
- generating simulation logs (105), the simulation logs being generated by the simulated modules (12, 13, 20) launched, transmitting said simulation logs to the topology simulation module, aggregating, analysing and displaying said simulation logs on a screen of a user interface,
- a user interacting (104) with said launched simulated modules (12, 13, 20), said interacting (104) being performed via the topology simulation module (11) through said user interface.

7. The method for simulating an interconnection network (100) according to claim 6, wherein the interaction (104) includes a sub-step of parameterising (104a) at least one of the simulated modules (12, 13, 20) launched.

8. The method for simulating an interconnection network (100) according to one of claims 6 or 7, wherein the interaction (104) includes a sub-step of defining (104b) at least one communication scenario.

9. The method for simulating an interconnection network (100) according to any of claims 6 to 8, wherein the interaction (104) includes a sub-step of activating or deactivating (104c) at least one simulating module (12, 13, 20) launched.

10. The method for simulating an interconnection network (100) according to any of claims 6 to 9, wherein the interaction (104) includes:
- a sub-step of assigning (104d) an identifier to each simulated module (12, 13) launched, and
- a sub-step of generating (104e) for each simulated module (12, 13) launched, a local map describing the connection links (15) established between said launched simulated module (12, 13) and its neighbouring simulated modules.
